# EUROPÄISCHE PATENTANMELDUNG

(11) **EP 1 698 713 A1**
(43) Veröffentlichungstag der Anmeldung: **06.09.2006**
(21) Anmeldenummer: 05405217.0
(22) Anmeldetag: 01.03.2005
(51) Int. Cl.: C23C 8/00, C23C 14/14, C23C 14/06, C23C 16/26, C23C 28/00

(54) **Kratzfester Werkstoff und Verfahren zu seiner Herstellung**

(71) Anmelder: Ceco Ltd, 2505 Biel (CH)
(72) Erfinder: Bach, Michael, 2505 Biel (DE)

(57) **Zusammenfassung**

Ein hochwertiger bruchfester Gradientenwerkstoff (1, 10) mit extrem kratzfester, nicht deformierbarer Oberfläche umfasst einen hochfesten metallischen Kern (2, 12) mit einer Aussteifungszone (4, 14) an der Oberfläche sowie einer zusätzlichen Hartstoffbeschichtung (3, 13). Der metallische Kern (2, 12) besteht aus einer Stahl- oder Titanlegierung. An seiner Oberfläche wird z. B. über Diffusion die mindestens 80 µm tiefe Aussteifungszone (4, 14) mit wesentlich höher Härte erzeugt. Die Hartstoffschicht (3, 13) weist eine Härte von mindestens 1800 HV auf.

## Beschreibung

Gegenstand der vorliegenden Erfindung ist ein kratzfester Werkstoff gemäss Oberbegriff des Anspruchs 1 sowie ein Verfahren zu seiner Herstellung.

Um kratzfeste Komponenten herzustellen, werden bisher meist High-Tech-Keramiken sowie Hartmetalle oder Cermets mit einer Härte grösser 1200 HV (Härtegrad Vickers) in verschiedenen Anwendungsgebieten wie z.B. der Uhrenbranche eingesetzt. Aufgrund der hohen Härte sind diese Werkstoffe im Gegensatz zu Stahl sehr bruchempfindlich und neigen beim Anschlagen oder Aufprallen auf einen harten Boden zum spontanen Bruch. Mit den bestehenden Werkstoffen muss meistens auch ein Kompromiss zwischen Härte bzw. Kratzfestigkeit und Festigkeit eingegangen werden. Der meistverwendete Werkstoff ist Zirkonoxid, welcher zwar eine für eine High-Tech-Keramik relativ hohe Festigkeit von 1000 MPa (Megapascal) aufweist, die Härte hingegen mit 1200 HV nur eine limitierte Kratzfestigkeit bietet, d. h. viele Materialien wie Meeressand (Quarz) können Zirkoniumoxid bereits kratzen.

Auch die hohen Investitions- und Fertigungskosten sowie die speziell notwendigen Konstruktionen lassen nur eine limitierte Anwendung dieser Werkstoffe in gewissen Anwendungsgebieten zu.

Um die Kratzfestigkeit weiter zu steigern oder um Farbkombinationen herzustellen, können High-Tech-Keramiken oder Hartmetalle auch mit PVD- oder CVD-Hartstoffschichten oder Kombinationen aus CVD- und PVD-Hartstoffbeschichtung beschichtet werden, z.B. gemäss US-Patent US-4,640,869. Die beschichteten Werkstoffe wie das darin verwendete Hartmetall mit einer Härte von 1400 HV verhalten sich aber gleich bruchempfindlich wie die unbeschichtten Keramiken und Hartmetallkomponenten.

Auch sind bereits CVD-Diamantschichten mit einer Härte von 10'000 HV auf High-Tech-Keramiken wie Si₃N₄ sowie Hartmetallen mit sehr guter Kratzfestigkeit, aber limitierter Schlag- und Bruchfestigkeit abgeschieden worden.

Bei der Beschichtung von Titanlegierungen, wie in der Literatur (IDR Industrie Diamant Rundschau, Ausgabe 2/2003: M. Rüffer G. Heinrich u. S. Rosiwal, CVD-Diamant in der Humanmedizin) beschrieben, kann bei der CVD-Diamantbeschichtung einer TiAl6V4-Legierung eine bis zu 80 my (Mikrometer) dicke Zwischenschicht aus TiC und Alpha-Titan erzeugt werden. Da TiC aber eine kleinere Bruchzähigkeit von 3,8 MPa/mm³ aufweist als die Diamantschicht (5,3 MPa/mm³), wird für die bekannten zyklischen tribologischen Anwendungen von Diamant versucht, nur eine dünne TiC-Schicht für eine gute Haftfestigkeit der Diamantschicht zu erzielen. Bleibt die Ausbildung der Zwischenschicht aber im Bereich bis höchstens 80 my, kann ein Durchdrücken der Diamantschicht mit einem spitzen Gegenstand immer noch erfolgen. Auch sind die hochfesten Titanlegierungen nicht polierbar. Wird auf eine nicht polierte, rauhe Oberfläche eine an sich glatte, nanokristalline CVD Diamantschicht abgeschieden, so bildet sie den Untergrund ab. Diese rauhen Oberflächen sind zwar an sich kratzfest, mit einem weichen Stahl, Titan oder Aluminium kann man aber beim Darüberfahren bereits leicht einen Strich machen. Hierbei wird das weiche Metall so fest in die rauhe Oberfläche eingedrückt, dass es mit den üblichen Reinigungsverfahren nicht mehr entfernt werden kann.

Um bei dem heute meistverwendeten Stahlwerkstoff eine verbesserte Kratzfestigkeit zu erzielen, sind verschiedene PVD-Verfahren etabliert. Aufgrund des sehr weichen Stahlkernes (ca 200 HV) kann die wenige Mikrometer dicke und an sich kratzfeste PVD-Schicht trotz einer üblichen Härte von 2000 HV leicht mit einem spitzen Gegenstand durchgedrückt werden. Dieser Effekt ist in der Literatur als Eierschaleneffekt bekannt. Die Schichtstärken sind auf wenige Mikrometer limitiert, da bei grösseren Schichtdicken Spannungen zunehmen, welche zum Abplatzen der Schicht führen können. Bei den heute üblicherweise verwendeten 1-2 my dicken Schichten erfolgt die Abnützung z. B für Uhren an Ecken und Kanten bereits nach einigen Monaten.

Auch sind bereits Verfahren (z. B. CN-A-1366091) bekannt, um WC (Wolframkarbid) in die Oberfläche von Stahl zu diffundieren, um so eine höhere Abriebfestigkeit zu erzielen. Die Härten liegen dennoch in dem typischen Bereich für Hartmetalle zwischen 1200 HV bis 1400 HV und bietet daher nur eine bedingte Kratzfestigkeit.

Beim Stahl sind verschiedene Härteverfahren bekannt, um den Stahl an der Oberfläche thermisch oder chemisch zu härten. Neben dem klassischen Härten haben sich heute thermochemische Diffusionsverfahren wie Aufkohlen, Carbonitrieren, Gasnitrieren, Gasnitrocarburieren, Plasmanitrieren oder Borieren etabliert. Alle Verfahren haben aber spezifische Eigenschaften. So erzielt man mit dem Borieren hohe Härten von mehr als 1500 HV, aber nur in dünnen Diffusionszonen, typischerweise mit einer Dicke von höchstens 0,01 mm. Auch hier tritt der Eierschaleneffekt auf. Die Verfahren Nitrieren und Carbonitrieren weisen meist eine grössere Schichtdicke von 0,1 mm auf, erreichen jedoch eine geringere Härte von ca. 800 HV, welche nicht genügt, um gute Kratzfestigkeit und gutes Abrasionsverhalten zu gewähren.

Auch bekannt im Bereich Uhrenbranche ist das sog. Tegimentieren (Härten von Stahl in einer chemischen Lösung). Hierbei können aber ebenfalls an der Oberfläche Härten von maximal 1200 HV erzielt werden.

Neben den aufgezeigten Werkstoffen und Verfahren hat sich der Werkstoff Saphir als kratzfestes Uhrenglas mit einer Härte von 1800-2200 HV etabliert.

Ziel einer guten Kratzfestigkeit ist es somit, glatte, polierte Oberflächen mit einer Härte von mindestens 1800 HV zu erzielen, d. h. vergleichbar mit Saphir.

Eine Aufgabe der vorliegenden Erfindung ist daher ein Material oder Werkstoff mit metallischem Kern und kratzfesterer Oberfläche.

Eine andere Aufgabe der vorliegenden Erfindung ist ein Material mit metallischem Kern und kratzfesterer, glatter Oberfläche.

Ein Material, das wenigstens die erstgenannte Aufgabe erfüllt, ist im Anspruch 1 und ein Verfahren zu seiner Herstellung ist im ersten Verfahrensanspruch angegeben. Die jeweils abhängigen Ansprüche geben bevorzugte Ausführungsformen an.

Demgemäss umfasst das erfindungsgemässe Material (Werkstoff) einen metallischen Kern aus einer Titan- oder Stahllegierung. Die kratzfeste Oberfläche zeichnet sich durch eine Aussteifungszone aus, die wenigstens 80 µm (Mikrometer) dick ist, und deren Oberfläche mit einer Hartstoffbeschichtung versehen ist, die eine Härte von mindestens 1800 HV aufweist. Die Aussteifungszone weist dabei eine wesentliche höhere Härte als das Material des Kerns auf. Insbesondere zeichnet sich die Aussteifungszone dadurch aus, dass ihre Härte zur Hartstoffschicht hin zunimmt.

Die Erfindung soll weiter an bevorzugten Ausführungsbeispielen unter Bezugnahme auf Figuren erläutert werden. Es zeigen:
- Fig. 1: Aufbau eines ersten erfindungsgemässen Materials im Schnitt; und
- Fig. 2: analog Fig. 1 ein zweites erfindungsgemässes Material.

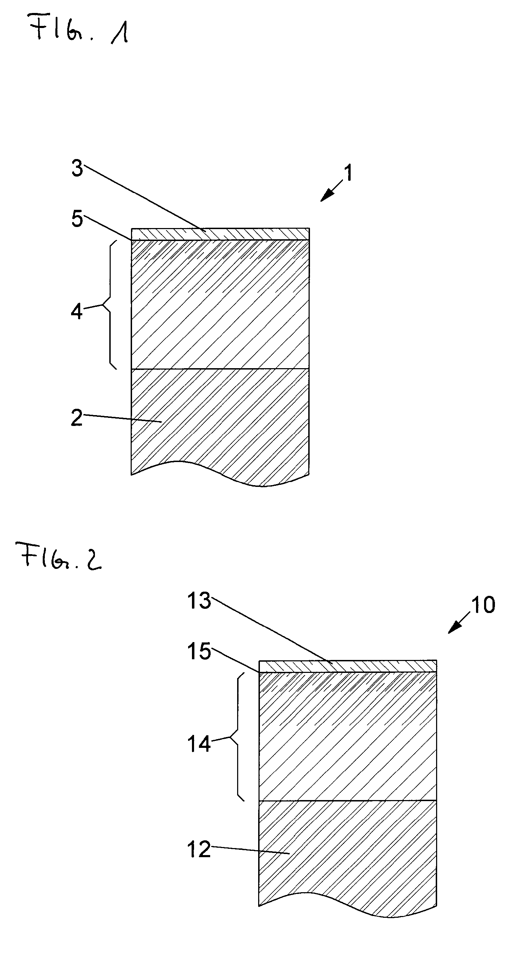

Das Material 1 gemäss Fig. 1 bietet eine grösstmögliche Kratzfestigkeit bei sehr guter Bruchsicherheit, nämlich eine Härte von 10'000 HV auf einem hochfesten metallischen Grundwerkstoff 2 einer Härte von höchstens 200 HV.

Diamant 3 ist die härteste bekannte Substanz und wird heute auch als Beschichtung mittels CVD-Prozessen abgeschieden. Durch einen stark modifizierten CVD-Prozess oder thermischen Prozess kann in einem ersten Schritt bei einer Titanlegierung in der Oberflächenzone 4 neben Apha-Titan auch TiC bis in eine Tiefe von mehreren zehntel Millimetern gebildet werden. Es entsteht eine Gradienten-Zone 4 von im z. B. 0,2 mm, die von der Härte des Grundmaterials Titan mit ca. 150 HV Härte zur Oberfläche 5 der Gradientenzone 4 hin eine Härtezunahme auf 600 HV hat. Der Bereich 0,05 mm bis zur Oberfläche 5 kann in herkömmlichen Mikrohärtemessverfahren leider nicht gemessen werden. Die chemische Zusammensetzung mit kontinuierlich stark ansteigender Zunahme von TiC zur Oberfläche hin lässt aber den Schluss zu, dass ein weiteres kontinuierliches Ansteigen der Härte von 600 HV bis zur Härte von TiC von mehr als 2000 HV erfolgt. Durch diese Härtung kann das Titan mit herkömmlichen Verfahren an der Oberfläche (wenige Mikrometer Materialabtrag) poliert werden. In einem zweiten CVD-Prozess erfolgt eine erneute Bildung einer TiC Schicht, auf die nanokristalliner Diamant 3 mit guter Adhäsion aufwächst.

Da die Diamantschicht transparent ist und zur Ausbildung von Newtonringen bei Schichtstärken von 1-3 my neigt, sollte eine Schichtdicke von mindestens 5 my abgeschieden werden. Durch die nanokristalline Struktur erhält die Schicht bei einer Härte von 10'000 HV eine sehr gute Festigkeit und sehr gute Glattheit.

Die nanokristalline Diamantschicht stellt in Punkto Kratzfestigkeit das absolute Maximum dar. Gleichzeitig können durch die Aussteifungsschicht 4 die Spannungen reduziert und der Eierschaleneffekt vermieden werden bei gleichzeitig guter Bruchsicherheit. Neben den mechanischen Vorzügen zeichnet sich diese Werkstoffkombination durch gute Hautverträglichkeit (Verwendung für Luxusgüter, Uhren, Schmuck), gute Biokompatibilität (Medizinalbranche) sowie extreme Leichtigkeit (Sportbranche) aus.

Fig. 2 zeigt ein Material 10 mit einer nicht aus Diamant bestehenden Hartstoffschicht 13 mit vergleichbaren Eigenschaften. Eine 5 my dicke metallfarbene, nanokristalline oder Multilayer-PVD-Schicht 13 auf Basis CrN oder eine goldfarbene Schicht 13 aus TiN ist auf eine nitrierte und borierte Edelstahloberfläche 15 abgeschieden. Ein Edelstahl der Qualität 316L wird hierzu in einem thermochemischen Diffusionsverfahren nach dem Gasnitrierprozess bei einer Temperatur von 480 °C bis 580 °C nitriert. Hierbei kann bis zu einer Tiefe von 0,6 mm eine graduelle Härtesteigerung von 180 HV Härte des Kerns 12 bis ca 700 HV Oberflächenhärte durch das Ausbilden einer graduellen Aussteifungsschicht 14 erzielt werden.

Mit einem anderen thermochemischen Diffusionsverfahren, dem Borieren, kann die Härte in der Randzone zur Oberfläche 15 hin in einer Tiefe von 5-10 my bei 800 °C bis 1000 °C zusätzlich graduell von 700 auf 2000 HV gesteigert werden. Ein Polieren der Oberfläche mit herkömmlichen Polierverfahren ermöglicht eine spiegelglatte Oberfläche, auf die eine stahlfarbene Multilayer-PVD-Schicht 13 auf Basis CrN mit einer Härte von 3000 HV oder eine goldfarbene Multilayerschicht 13 auf Basis TiN mit einer Härte von 1990 HV abgeschieden wird.

In beiden Fällen wird durch die anschliessende Beschichtung mit einer Multilayer- oder nanokristallinen PVD- oder CVD-Hartstoffschicht eine hoch polierte, kratzfeste, nichteindrückbare und abrasionsbeständige Oberfläche erzielt.

Insgesamt wird ein hochwertiger bruchfester, Gradientenwerkstoff mit extrem kratzfester, nicht deformierbarer Oberfläche erhalten, der aus einem hochfesten metallischen Kern mit einer Aussteifungszone an der Oberfläche sowie einer zusätzlichen Hartstoffbeschichtung besteht. Der metallische Kern besteht aus einer Stahl- oder Titanlegierung, an deren Oberfläche über Diffusion eine mindestens 80 my tiefe Aussteifungszone mit wesentlich höherer Härte als der metallische Kern erzeugt wurde, sowie einer zusätzlichen Hartstoffbeschichtung mit einer Härte grösser als 1800 HV.

Aus den beschriebenen Ausführungsbeispielen sind dem Fachmann Abwandlungen zugänglich, ohne den Schutzbereich der Erfindung zu verlassen, der durch die Ansprüche definiert ist.

Denkbar ist z. B.:
- Andere bekannte CVD- oder PVD-Hartstoffschichten wie TiC, TiN , TiB oder CrN, DLC ("Diamond like Carbon") können auf Titan- oder Stahllegierungen mit einer Aussteifungszone spannungsfrei in grösseren Schichtdicken abgeschieden werden.
- Die Aussteifungszone kann gezielt im CVD-Prozess oder in einer speziellen Vorbehandlung hergestellt werden.

## Patentansprüche

1. Werkstoff (1,10) mit einem Kern (2, 12) aus einer Titan- oder Stahllegierung und mit einer Hartstoffschicht (3, 13) an der Oberfläche (5, 15), **dadurch gekennzeichnet, dass** der Kern eine Aussteifungszone (4, 14) unter der Hartstoffschicht aufweist, wobei die Aussteifungszone eine wesentlich höhere Härte als der Kern und eine Tiefe von mindestens 80 my und die Hartstoffschicht eine Dicke von mindestens 3 my und eine Härte von mindestens 1800 HV aufweist.

2. Werkstoff (1, 10) gemäss Anspruch 1, **dadurch gekennzeichnet, dass** die Aussteifungszone (4, 14) eine Zone mit zur Hartstoffschicht (3, 13) hin ansteigendem Anteil wenigstens eines zweiten Hartstoffs aufweist.

3. Werkstoff (1,10) gemäss Anspruch 2, **dadurch gekennzeichnet, dass** die Zusammensetzung des zweiten Hartstoffs eine Komponente des Materials des Kerns (2, 14) umfasst.

4. Werkstoff (1, 10) gemäss Anspruch 2 oder 3, **dadurch gekennzeichnet, dass** die Aussteifungszone (4, 14) an der Grenze (5, 15) zur Hartstoffschicht im wesentlichen nur aus dem zweiten Hartstoff besteht.

5. Werkstoff (1, 10) gemäss einem der Ansprüche 1 bis 4, **dadurch gekennzeichnet, dass** die Legierung des Kerns (2, 12) Bestandteile aufweist, aus denen durch nachträgliche Behandlung in der Aussteifungszone (4, 14) Carbide, Nitride und/oder Boride bildbar sind.

6. Werkstoff (1, 10) gemäss einem der Ansprüche 1 bis 5, **dadurch gekennzeichnet, dass** der metallische Kern (2, 12) aus einem Metal-Matrix-Composite (MMC) besteht, in den Carbide, Nitride und/oder Boride eingelagert sind.

7. Werkstoff (1, 10) gemäss einem der Ansprüche 1 bis 6, **dadurch gekennzeichnet, dass** die Hartstoffbeschichtung aus einer "Diamond-like-carbon"-Beschichtung oder einer reinen CVD-Diamantbeschichtung besteht.

8. Werkstoff (1, 10) gemäss einem der Ansprüche 1 bis 7, **dadurch gekennzeichnet, dass** die Hartstoffschicht(3, 13) eine nanokristalline Struktur oder eine Multilayerstruktur aufweist.

9. Verfahren zur Herstellung 8 des Werkstoffs (1, 10) gemäss einem der Ansprüche 1 bis 7, **dadurch gekennzeichnet, dass** die Bildung der Aussteifungszone (4, 14) sowie die Beschichtung mit dem eigentlichen Hartstoff (3, 13) in einem einzigen CVD-Prozess erfolgt.

10. Verfahren zur Herstellung 9 des Werkstoffs (1, 10) gemäss einem der Ansprüche 1 bis 8, **dadurch gekennzeichnet, dass** die Bildung der Aussteifungszone (4, 14) und die Beschichtung mit dem Hartstoff (3, 13) in verschiedenen Prozessschritten erfolgt.

11. Verfahren gemäss Anspruch 10, **dadurch gekennzeichnet, dass** nach der Bildung der Aussteifungszone (4, 14) und vor der Beschichtung mit Hartstoff (3, 13) ein Polierschritt erfolgt.

12. Verfahren gemäss einem der Ansprüche 9 bis 11, **dadurch gekennzeichnet, dass** die Beschichtung mit Hartstoff (3, 13) mittels PVD-Technologie erfolgt.

13. Verfahren gemäss einem der Ansprüche 9 bis 12, **dadurch gekennzeichnet, dass** die Hartstoffschicht (3, 13) mittels CVD-Technologie erzeugt wird.

14. Verfahren gemäss einem der Ansprüche 9 bis 13, **dadurch gekennzeichnet, dass** die Aussteifungszone (4, 14) durch Bildung von Carbiden, Nitriden, Boriden oder Mischkristallen daraus erzeugt wird

15. Verfahren gemäss einem der Ansprüche 9 bis 14, **dadurch gekennzeichnet, dass** die Aussteifungszone (4, 14) mittels eines thermochemischen Diffusionsverfahrens wie Aufkohlen, Carbonitrieren, Gasnitrieren, Gasnitrocarburieren, Plasmanitrieren oder Borieren, erfolgt.
